# FASCICULE DE BREVET EUROPEEN

(11) **EP 0 660 525 B1**
(45) Date de publication et mention de la délivrance du brevet: **21.04.1999**
(21) Numéro de dépôt: 94402985.9
(22) Date de dépôt: 22.12.1994
(51) Int. Cl.: H03K 19/21, H03K 5/00, H03B 19/00

(54) **Multiplieur de fréquence comportant un arbre de portes logiques OU-Exclusif de type CMOS**
Frequenzmultiplizierer mit einer Baumstruktur von CMOS logischen Gattern des Typs "Exclusiv-ODER"
Frequency multiplier with a tree structure of CMOS logic gates of the type "Exclusive-OR"

(30) Priorité: 24.12.1993 FR 9315631
(43) Date de publication de la demande: 28.06.1995
(73) Titulaire: BULL S.A., 78430 Louveciennes (FR)
(72) Inventeur: Marbot, Roland, F-78000 Versailles (FR); Le Bihan, Jean-Claude, F-92120 Montrouge (FR); Cofler, Andrew, F-75015 Paris (FR); Nezamzadeh-Moosavi, Reza, F-78390 Bois d'Arcy (FR)
(74) Mandataire: Denis, Hervé

(56) Documents cités:
- EP-A- 0 265 047
- EP-A- 0 441 684
- WO-A-93/17500
- US-A- 5 180 994
- IBM TECHNICAL DISCLOSURE BULLETIN, vol.32, no.7, Décembre 1989 pages 464 - 467 'fast parity tree'
- PROCEEDINGS OF 32ND MIDWEST SYMPOSIUM ON CIRCUITS AND SYSTEMS, AUGUST 14-16, 1989, CHANCELLOR HOTEL AND CONVENTION CENTER CHAMPAIGN, ILLINOIS pages 829 - 832 D. HUANG ET AL: 'On CMOS Exclusive OR Design'
- IEEE TRANSACTIONS ON COMPUTERS, vol.42, no.2, Février 1993, NEW YORK, US pages 179 - 189 NIRAJ K. JHA: 'Fault Detection in CVS Parity Trees with Application to Strongly Self-Checking Parity and Two-Rail Checkers'
- IBM TECHNICAL DISCLOSURE BULLETIN, vol.26, no.3A, Août 1983 page 990-991 I. HERNANDEZ, JR.: 'Frequency multiplier using delay circuits'

## Description

### Domaine technique.

L'invention se rapporte aux arbres de portes électroniques de type OU-Exclusif, effectuant la fonction logique OU-Exclusif ou la fonction inverse NON-OU-Exclusif et appelées couramment portes de type XOR (XOR ou NXOR). Elle a plus particulièrement pour objet un arbre de portes de type XOR disposées en plusieurs couches, chaque porte d'une couche ayant deux entrées et une sortie connectée à une entrée d'une porte de la couche adjacente. L'invention s'applique notamment aux multiplieurs de fréquence incorporant de tels arbres. Elle a aussi pour objet le circuit intégré incorporant un tel arbre dans une combinaison telle que celle constituant un multiplieur de fréquence. L'intégration est faite en technologie MOS (Métal-Oxyde-Silicium) et plus particulièrement celle à transistors complémentaires, dite CMOS.

### L'art antérieur.

Dans la publication IBM' Technical Disclosure Bulletin, Vol. 26, No. 3A, August 1983, pages 990-991, I. Hernandez, Jr : "Frequency multiplier using delay circuits" est décrit un multiplieur de fréquence formé d'une chaîne de circuits à retard dont les sorties sont connectées aux entrées respectives d'un arbre de portes XOR. L'arbre illustré dans cette publication est fait de portes à deux entrées et une sortie connectée à une entrée d'une porte de la couche voisine, l'autre entrée étant directement connectée à la sortie d'un circuit à retard respectif de la chaîne. Chaque porte constitue ainsi une couche différente de l'arbre. En d'autres termes, l'arbre a autant de couches que la chaîne a de circuits à retard et chaque couche a deux branches, l'une par laquelle on remonte aux portes précédentes et l'autre accédant à une sortie respective de la chaîne. Il existe donc une dissymétrie entre les temps de propagation des signaux dans les deux branches, cette dissymétrie augmentant au fur et à mesure que l'on approche de la sortie de l'arbre. Dans le signal de sortie de l'arbre, la période de récurrence d'un même front peut donc varier dans de fortes proportions si leur fréquence est élevée. Le multiplieur de fréquence décrit-dans cette publication n'est donc pas adapté pour les très hautes fréquences, par exemple supérieures à un gigabit par seconde.

Le document EP-A-0441684 décrit un multiplieur de fréquence dans lequel les sorties successives de la chaîne de circuits à retard sont pilotées par un circuit verrouillé en phase et sont toutes appliquées aux entrées respectives de la première couche de l'arbre de portes XOR. Les couches suivantes ont successivement la moitié moins de portes, la dernière couche n'ayant qu'une porte. Cet arbre assure donc une propagation sensiblement la même pour chacun des signaux d'entrée et convient aux très hautes fréquences.

Cependant, pour de telles fréquences, l'arbre doit garantir des temps de propagation égaux depuis ses entrées respectives jusqu'à la sortie, et cela quel que soit le front à propager. Quand il en est ainsi on dit que l'arbre est symétrique. La symétrie implique donc que toutes les portes de l'arbre soient dessinées de façon identiques dans le circuit intégré, qu'elles fournissent des temps de propagation égaux quelle que soit l'entrée active et quel que soit le front à propager, et que leurs charges soient identiques.

Pour satisfaire à toutes ces contraintes un premier problème se pose du fait qu'une porte de type XOR peut inverser ou non un signal appliqué à sa première entrée, en fonction de l'état de sa seconde entrée, cet état restant stable pendant la commutation. Par conséquent, selon les états des entrées de l'arbre, un front montant en sortie peut n'être généré que par des fronts montants dans l'arbre, par une majorité de fronts descendants ou par toute configuration intermédiaire. Réciproquement, ceci vaut également pour un front descendant en sortie de l'arbre.

D'autres problèmes se posent en employant la technologie des circuits intégrés à transistors complémentaires à effet de champ à grille isolée, dite couramment technologie CMOS (Complementary Metal-Oxide-Silicon). Cette technologie offre l'avantage d'utiliser des portes faites sur la base du montage inverseur comprenant simplement deux transistors complémentaires NMOS (de type n) et PMOS (de type p) connectés en série entre les deux potentiels d'alimentation Vdd et Vss. Le signal d'entrée est appliqué sur les grilles des deux transistors et le signal de sortie est fourni au point de liaison des drains des deux transistors. Le transistor PMOS assure les commutations de sortie des fronts montants, tandis que les fronts descendants sont générés par le transistor NMOS. Cette dissymétrie, inhérente à cette technologie, empêche donc de satisfaire la contrainte de symétrie de l'arbre. Cette contrainte se répercute notamment dans l'égalisation des charges. On satisfait en partie à cette dernière contrainte en égalisant les longueurs de câblage entre portes adjacentes, mais la contrainte se situe alors essentiellement dans l'égalisation des charges internes à de telles portes.

Enfin, en supposant que ces deux problèmes soient résolus, il faut encore que les entrées directes et inversées des portes d'entrée de l'arbre permutent simultanément en sens opposés. Cette condition n'est généralement pas remplie en technologie CMOS, pour laquelle la seule façon d'obtenir l'inverse d'un signal est de rajouter un inverseur. Cependant, le temps de traversée de cet inverseur fait que le signal direct et son inverse ne commutent pas exactement au même moment.

Le document IBM Technical Disclosure Bulletin, vol. 32, n° 7, décembre 1989, pages 464-467, New York, US, "Fast Parity Tree" décrit un arbre de parité permettant un calcul rapide du bit de parité d'un octet. La rapidité est accrue grâce a l'emploi de portes XOR et XNOR de technologie CMOS, qui ne font intervenir que deux étages de transistors au lieu de 7 étages dans les portes antérieures. Les portes nécessitant des signaux complémentaires de chaque signal d'entrée, chaque porte XOR est associée à une porte complémentaire XNOR pour fournir simplement les signaux complémentaires aux portes suivantes. Cependant, le problème de la rapidité de calcul du bit de parité n'a aucun lien avec les problèmes exposés ci-dessus relatifs à un multiplieur de fréquence. Selon une des raisons majeures, la dissymétrie des signaux dans un arbre de parité n'affecte pas le calcul du bit de parité. Au contraire, à cause d'une multiplication de la fréquence, la dissymétrie devient une condition fondamentale, surtout lorsque le signal en résultant doit servir d'horloge. Selon une autre raison majeure, la symétrie des signaux fait que chaque couche de l'arbre décale les signaux d'un même retard et rend l'arbre insensible au retard des signaux dans chaque couche.

Le brevet US n° 5 180 994 décrit un oscillateur en anneau commandé en tension, formé d'un nombre pair d'étages inverseurs différentiels en cascade. Les signaux de sortie complémentaires des étages inverseurs sont respectivement appliqués à des circuits mélangeurs, de préférence formés de portes OU-Exclusif pleinement équilibrées de type CML différentiel, recevant chacun deux signaux complémentaires d'entrée déphasés de 90° l'un de l'autre et délivrant un signal complémentaire de sortie de fréquence double de celle des signaux d'entrée.

### L'invention.

La présente invention permet d'obtenir en technologie CMOS un arbre fournissant des temps de propagation parfaitement égaux quels que soient l'entrée active de l'arbre et le front à propager.

L'invention a pour objet un arbre de portes de type OU-Exclusif à deux entrées, les portes étant disposées par couches successives depuis une couche d'entrée recevant les signaux d'entrée de l'arbre, la sortie- de chaque porte étant connectée à une entrée d'une porte de la couche adjacente, caractérisé en ce que chaque porte comprend deux cellules commutant sensiblement simultanément en réponse aux deux signaux complémentaires respectifs de l'une des deux entrées et fournissant des signaux de sortie respectifs représentatifs des fonctions complémentaires du type OU-Exclusif.

L'invention a pour objet un multiplieur de fréquence tel que défini par la revendication 1.

L'invention a aussi pour objet le circuit intégré qui incorpore ce multiplieur de fréquence.

L'invention ressort de la description des exemples illustrés dans les dessins annexés, dans lesquels :
- la figure 1 illustre schématiquement la structure d'un multiplieur de fréquence incorporant un arbre de portes XOR ;
- la figure 2 est un diagramme illustrant le fonctionnement du multiplieur de fréquence représenté sur la figure 1 ;
- la figure 3 illustre schématiquement un premier exemple de réalisation en technologie CMOS d'une porte de l'arbre représenté sur la figure 1 ;
- la figure 4 illustre schématiquement un second exemple de réalisation en technologie CMOS d'une porte de l'arbre représenté sur la figure 1 ; et
- la figure 5 illustre schématiquement une cellule d'entrée génératrice des signaux complémentaires d'une entrée d'une porte ,telle que représentée sur la figure 3 ou 4, de la couche d'entrée de l'arbre représenté sur la figure 1.

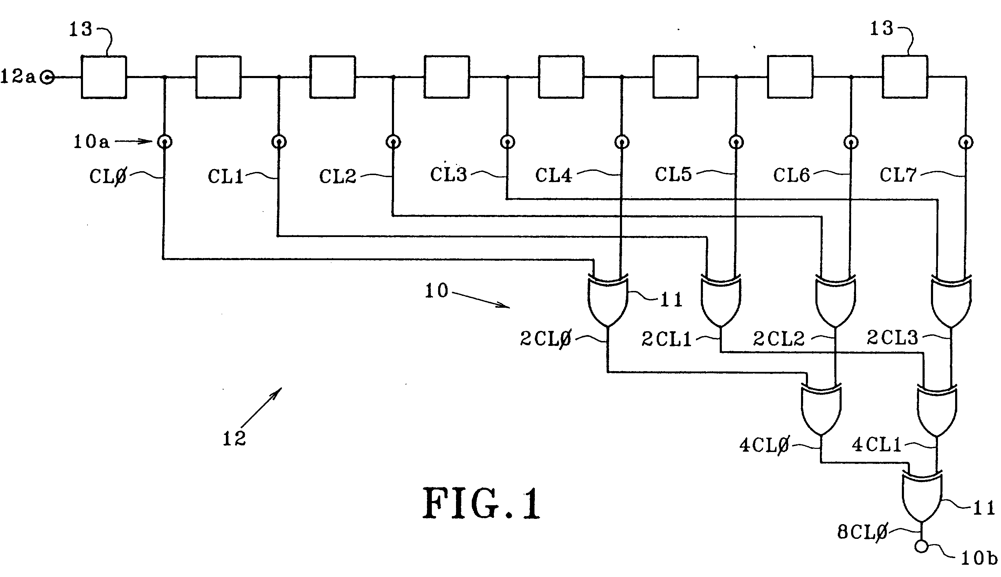

Dans la figure 1, un arbre 10 de portes 11 de type XOR a une bome d'entrée 10a recevant huit signaux d'entrée CL0-CL7 et une borne de sortie 10b délivrant un signal de sortie 8CL0. Les portes 11 sont disposées en plusieurs couches, trois dans l'exemple illustré, et ont leurs sorties respectives connectées à une entrée d'une porte de la couche adjacente. La première couche qui constitue la couche d'entrée comprend quatre portes dont les huit entrées constituent la borne d'entrée 10a et reçoivent respectivement les huit signaux d'entrée CL0-CL7, et dont les quatre sorties délivrent quatre signaux respectifs 2CL0-2CL3. La seconde couche comprend deux portes 11 délivrant les deux signaux respectifs 4CL0 et 4CL1, et la troisième couche constituant la couche de sortie ne comprend qu'une porte 11 délivrant le signal de sortie 8CL0. L'arbre 10 illustré forme un multiplieur de fréquence 12 avec une chaîne de circuits à retard 13. Le multiplieur de fréquence 12 a une borne d'entrée 12a recevant un signal extérieur, un signal d'horloge CL par exemple, et la chaîne comprend huit circuits à retard 13, dont les sorties respectives fournissent les huit signaux d'entrée CL0-CL7.

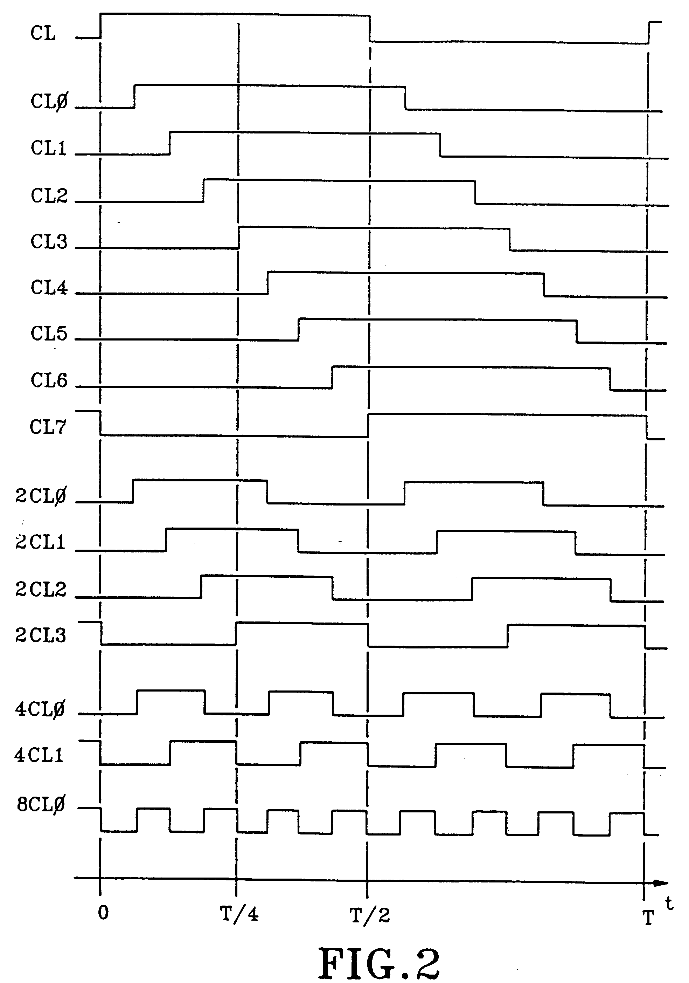

La figure 2 est un diagramme représentant les formes d'onde de tous les signaux indiqués dans la figure 1 et illustrant ainsi le fonctionnement du multiplieur de fréquence 12. Les huit circuits à retard produisent des retards respectifs égaux et partageant l'intervalle de temps T de deux fronts récurrents prédéterminés du signal d'horloge CL, les fronts montants dans l'exemple illustré. Le signal d'horloge CL est donc successivement décalé de T/8 pour fournir les huit signaux d'entrée CL0-CL7. La fréquence de ces signaux est multipliée par deux dans chacune des couches successives de l'arbre 10. Dans l'exemple illustré, le signal de sortie 8CL0 a une fréquence huit fois plus élevée que celle du signal d'horloge CL.

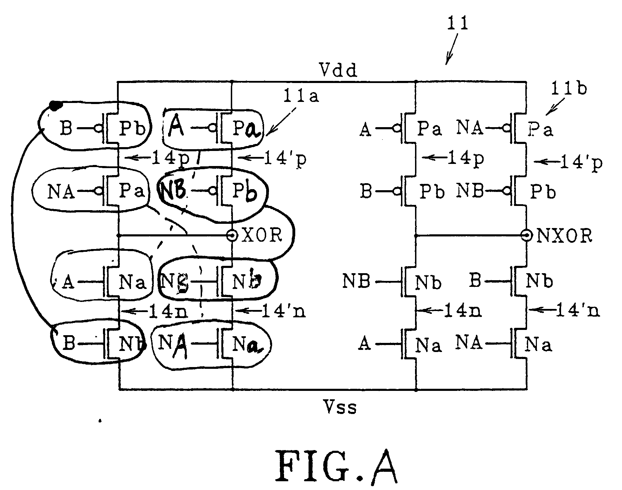

La figure 3 illustre un premier exemple de réalisation en technologie CMOS d'une porte 11 du type décrit dans le document précité IBM Technical Disclosure Bulletin, vol. 32, n° 7 "Fast Parity Tree". Chaque porte 11 comprend deux cellules complémentaires 11a et 11b fournissant respectivement des signaux de sortie XOR, NXOR représentatifs des fonctions complémentaires de type OU-Exclusif des signaux d'entrée. Dans l'exemple illustré dans la figure 3, les signaux d'entrée sont désignés par A et B et leurs inverses sont désignés par NA et NB. Ainsi A, NA et B, NB sont les quatre signaux complémentaires des deux entrées. Chacune des cellules illustrées 11a et 11b est faite de deux paires 14, 14' de branches complémentaires 14n, 14p et 14'n, 14'p réunies en un point commun constituant la sortie de la cellule et délivrant les signaux respectifs XOR et NXOR. Chaque branche comprend deux transistors ayant leurs trajets de courant drain-source connectés en série entre un potentiel d'alimentation et le point commun. Les deux branches 14p et 14'p sont reliées au potentiel haut d'alimentation Vdd et comprennent deux transistors Pa, Pb de type PMOS, tandis que les deux autres branches 14n et 14'n sont reliées au potentiel bas d'alimentation Vss et comprennent deux transistors Na, Nb de type NMOS. Dans la paire de branches complémentaires 14p et 14n, la paire de transistors complémentaires Pa et Na reçoivent sur leurs grilles l'entrée A, tandis que dans la paire de branches complémentaires 14'p et 14'n la paire de transistors complémentaires Pa et Na reçoivent sur leurs grilles le signal complémentaire NA de l'entrée A. Les deux paires de transistors complémentaires Pa, Na sont montées chacune en série avec les deux transistors complémentaires respectifs Pb, Nb recevant sur leurs grilles les signaux complémentaires B, NB de l'autre entrée. Ainsi les quatre branches de chaque cellule sont totalement symétriques. A chaque instant, deux branches complémentaires sont actives dans une cellule. Supposons par exemple que B=0, NB=1, et que A est le signal commutant. Dans la paire de branches 14 de la cellule XOR 11b, le transistor Pb et le transistor Nb sont actifs. La sortie NXOR commute donc sous l'effet de la commutation de A dans la branche 14p ou dans la branche 14n selon que le front de l'entrée A est descendant ou montant. L'autre paire de branches 14' est inactive dans ce cas. Symétriquement, dans la cellule XOR 11a, ce sont les branches complémentaires 14p et 14'n qui sont actives pour répondre respectivement à un front montant ou un front descendant de NA. On voit donc que les deux cellules 11a, 11b commutent sensiblement simultanément en réponse aux deux signaux complémentaires respectifs de l'une des deux entrées, la porte 11b sous l'effet de A et la porte 11a sous l'effet de NA, et toutes les deux de façon très symétrique. Il en est de même pour l'autre entrée B. En bref, chaque porte 11 comprend deux cellules 11a, 11b commutant sensiblement simultanément en réponse aux deux signaux complémentaires respectifs A, NA et B, NB de l'une des deux entrées et fournit des signaux de sortie respectifs représentatifs des fonctions complémentaires XOR et NXOR du type OU-Exclusif.

Toutefois, chaque branche est constituée de deux transistors en série. Pour que les temps de propagation de l'une ou l'autre entrée à la sortie soient identiques, une solution consiste à grossir le transistor lié à Vdd ou à Vss par rapport au transistor lié à la sortie. Par exemple, dans une technologie à 0,5 micron, le rapport des tailles de deux transistors de la branche serait de 1.25. Ce rapport assurerait des temps de propagation sensiblement identiques. Cependant, il peut s'avérer que cette solution soit difficilement réalisable par certains procédés technologiques ou dans certaines conditions. Par exemple, il est possible de ne pas trouver un rapport entre les deux transistors d'une même branche tel que les temps de propagation soient comparables.

La figure 4 illustre une solution assurant une symétrie parfaite des temps de propagation. Cette solution consiste à dédoubler chacune des branches 14p, 14n, 14'p et 14'n en des branches jumelles 114p, 114n, 114'p et 114', dans lesquelles les entrées sont croisées. Par exemple, dans la cellule XOR 11a illustrée dans la figure 3, la branche 14p recevant les entrées B et NA est, dans la cellule correspondante de la figure 4, dédoublée en branches jumelles 14p, 11'p dans lesquelles les entrées sont croisées: la branche 14p reste inchangée tandis que dans la branche 114p l'entrée NA est appliquée sur le transistor proche du potentiel Vdd et réciproquement pour l'entrée B. Ainsi, l'impédance d'entrée vue par l'entrée NA est celle formée par les deux transistors en série de la branche 14p et celle, en parallèle, du transistor Pa proche de Vdd dans la branche 114p. De même, l'impédance d'entrée vue par l'entrée B est celle formée par le transistor Pb de la branche 14p et celle, en parallèle, des deux transistors en série de la branche 114p. Plus généralement, grâce au croisement des entrées dans les branches jumelles, chacune des entrées A, NA, B et NB voit sensiblement la même impédance d'entrée constituée du montage parallèle des deux transistors en série dans une branche et du transistor proche du potentiel d'alimentation dans la branche jumelle. L'équilibrage des impédances d'entrée confère aux signaux d'entrée A, NA, B et NB les mêmes temps de propagation dans chacune des cellules 11a et 11b d'une porte 11 et conserve leur symétrie.

Nous pouvons alors analyser le comportement de l'arbre 10 constitué de couches de portes 11 telles qu'illustrées dans les figures 3 et 4. Supposons, pour la clarté de l'explication, que la sortie 10b de l'arbre 10 commute par l'effet d'une chaîne qui ne passe que par les entrées A ou NA des portes dans les différentes couches. Compte tenu de la symétrie totale des portes 11 entre les entrées A et B, cette situation n'a pas de comportement particulier par rapport aux autres entrées B et NB. Supposons aussi que la sortie 10b de l'arbre 10 commute par un front montant, sachant que le raisonnement serait le même pour un front descendant. Nous savons que ce front montant de sortie est généré par un transistor P dans la dernière couche de portes 11 de l'arbre. Nous ignorons si ce transistor P était celui commandé par le signal NA, car cela dépend de l'état du signal B. Mais la symétrie totale entre A ou NA et la sortie fait que cette incertitude n'a pas d'incidence sur le résultat. Ce que nous savons avec certitude, c'est que le signal A ou NA qui a fait commuter la sortie 10b vers le niveau haut était un signal à front descendant. Le signal complémentaire respectif NA ou A était donc à front montant, qui n'a pas eu d'effet dans la commutation de sortie puisqu'il était appliqué sur les branches inactives des cellules. Le signal actif à front descendant a donc été généré dans l'avant-dernière couche de portes 11 par un transistor N. Le même raisonnement que précédemment s'applique à l'avant-dernière couche de l'arbre 10. En bref, ce transistor N actif (Na ou Nb) a commuté sous l'effet d'un front montant. En continuant le raisonnement jusqu'aux entrées 10a de l'arbre 10 et si le nombre de couches de l'arbre est pair, le chemin de commutation passe par autant de transistors N que de transistors P si le nombre de couches de l'arbre est pair. Dans ces conditions, le temps de propagation dans l'arbre 10 est le même pour chaque front.

La contrainte de la symétrie est maintenant reportée à l'entrée 10a de l'arbre 10, où les entrées complémentaires doivent commuter simultanément en sens opposé. Cette condition n'est pas courante dans les technologies CMOS pour lesquelles la seule façon d'obtenir l'inverse d'un signal est de rajouter un inverseur. Cependant, à cause de l'insertion de cet inverseur, le signal inverse se trouve décalé du signal direct de la période de temps de traversée de l'inverseur. A cette dissymétrie s'ajoute dans une moindre mesure la dissymétrie entre transistor P et le transistor N de cet inverseur.

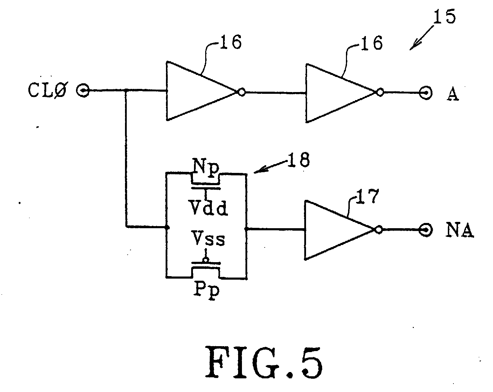

Pour résoudre cette difficulté, les signaux complémentaires A, NA et B, NB appliqués à chacune des portes 11 de la première couche de l'arbre 10 sont issus de deux signaux d'entrée respectifs des huit signaux d'entrée CL0-CL7 de la figure 1 et sont générés par deux cellules d'entrée 15 respectives. La figure 5 illustre un exemple de réalisation de la cellule d'entrée 15 relative au signal d'entrée CL0 issu de la borne d'entrée correspondante 10a de l'arbre 10 et appliqué à l'entrée de la cellule d'entrée 15. Dans la cellule 15 illustrée, l'entrée CL0 passe par une voie directe délivrant l'entrée A et par une voie inverseuse délivrant l'entrée inverse NA. La voie directe comprend deux inverseurs CMOS 16 en série, tandis que la voie inverseuse comprend un inverseur CMOS 17 en série avec un montage 18 fait de deux transistors de passage (pass-transistor) Np et Pp de types complémentaires, ayant leurs trajets de courant drain-source en parallèle et leurs grilles connectées aux potentiels d'alimentation respectifs Vdd et Vss. La voie inverseuse inverse le signal d'entrée CL0 grâce à l'inverseur 17 et les retardent grâce au montage 18 à transistors de passage. L'inverseur 17 et le montage 18 sont dimensionnés pour générer des temps de propagation les plus égaux possible aux temps de propagation respectifs dans les deux inverseurs 16 de la voie directe. Bien sûr, l'inverseur 17 et le montage 18 ne fonctionnent pas de la même façon, donc cette compensation ne peut qu'être approximative. Mais la cellule d'entrée 15 n'est à traverser qu'une fois, alors que les portes 11 sont traversées autant de fois qu'il y a de couches dans l'arbre 10. La différence de temps de propagation qui pourra alors apparaître, et qu'on cherchera à minimiser, ne se cumulera donc pas.

Dans la pratique, on est arrivé avec les portes illustrées dans les figures 3 et 4 à égaliser les temps de propagation dans un arbre 10 de quatre couches avec une précision de quelques dizaines de picosecondes, malgré les dispersions de fabrication, de températures et de tension d'alimentation.

Diverses variantes peuvent être apportées par l'homme du métier à l'arbre 10 qui vient d'être décrit. Par exemple, on peut voir que la cellule d'entrée 15 peut être limitée une voie incluant un inverseur 16 fournissant l'entrée NA et une voie incluant le montage 18 et fournissant l'entrée A.

L'invention a donc pour objet un multiplieur de fréquence comprenant une chaîne de circuits à retard dont les sorties sont appliquées aux entrées respectives d'un arbre de portes de type XOR conforme à l'invention. La chaîne peut être simplement celle décrite dans la publication citée en introduction, ou celle décrite dans le document aussi cité en introduction, ou encore sous d'autres formes. D'une manière générale, il est bien connu de l'homme du métier de faire avec un arbre de portes de type OU-Exclusif n'importe quel facteur de multiplication, pair ou impair, avec un nombre pair ou impair de couches, dans lesquelles les deux entrées de chacune des portes peuvent être diversement connectées pour obtenir le facteur de multiplication désiré. En d'autres termes, si le nombre de couches est théoriquement impair pour construire de façon minimale un arbre en technologie CMOS ayant le facteur de multiplication désiré, il est bien connu de rajouter une couche et d'interconnecter en conséquence les portes de chaque couche de façon à obtenir le facteur de multiplication désiré. Cependant, on sait qu'un nombre impair de couches n'introduit que le défaut de la dernière couche impaire, puisque le nombre pair de couches précédentes garantit une symétrie parfaite. Par conséquent , si le défaut global d'un arbre ayant un nombre impair de couches est inférieur aux tolérances admises, le nombre impair peut être maintenu.

## Revendications

1. Multiplieur de fréquence comprenant un arbre (10) de portes de type OU-Exclusif (11) à deux entrées (A, B), les portes étant disposées par couches successives depuis une couche d'entrée recevant des signaux d'entrée (CL0-CL7) successivement retardés entre eux pour partager une période (T) correspondant à une fréquence donnée, jusqu'à une couche de sortie formée d'une seule porte délivrant un signal de sortie de fréquence multiple de ladite fréquence donnée, la sortie de chaque porte à l'exception de la porte de sortie étant connectée à une entrée d'une porte de la couche suivante adjacente, chacune des deux entrées de chaque porte étant représentative de deux signaux complémentaires (A, NA ; B, NB) et chaque porte comprenant deux cellules (11a, 11b) qui commutent sensiblement simultanément en réponse aux deux signaux complémentaires respectifs de l'une des deux entrées et qui fournissent des signaux de sortie respectifs représentatifs des fonctions complémentaires (XOR, NXOR) du type OU-Exclusif et constitutifs de ladite sortie de la porte, caractérisé en ce que chaque cellule étant faite en une technologie à transistors complémentaires à effet de champ à grille isolée (CMOS), chaque cellule comprend une première paire de transistors complémentaires (Na, Pa) recevant l'une (A) des entrées et une seconde paire de transistors complémentaires (Na, Pa) recevant le signal complémentaire (NA) de ladite entrée, les deux paires de transistors étant réunies en un point commun entre les drains des transistors complémentaires et chacun des transistors de ces deux paires étant monté en série avec l'un de deux transistors complémentaires respectifs (Nb, Pb) recevant les signaux complémentaires de l'autre entrée (B, NB), les deux paires et leurs transistors complémentaires formant quatre branches (14n, 14p, 14'n, 14'p) réunies au point commun constituant aussi la sortie de la cellule, chacune (14p) des branches étant dédoublée en deux branches jumelles (14p, 114p) en parallèle dans lesquelles les entrées sont croisées.

2. Multiplieur de fréquence selon la revendication 2, caractérisé en ce que le nombre de couches de l'arbre est pair.

3. Multiplieur de fréquence selon la revendication 1 ou 2, caractérisé en ce que les signaux d'entrée (CL0-CL7) de l'arbre sont appliqués aux entrées respectives des portes de la couche d'entrée par l'intermédiaire de cellules d'entrée (15) génératrices des signaux complémentaires symétriques de chacun des signaux d'entrée.

4. Multiplieur de fréquence selon la revendication 3, caractérisé en ce que chaque cellule d'entrée comprend une voie incluant un inverseur (16) et une seconde voie incluant un montage (18) de transistors complémentaires de passage (Np, Pp) ayant leurs trajets drain-source connectés en parallèle et leurs grilles connectées à deux potentiels d'alimentation (Vdd, Vss).

5. Circuit intégré, caractérisé en ce qu'il incorpore un multiplieur de fréquence tel que défini par l'une des revendications 1 à 4.

## Patentansprüche

1. Frequenzmultiplizierer, mit einer Baumstruktur (10) aus Gattern des Exklusiv-ODER-Typs (11) mit zwei Eingängen (A, B), wobei die Gatter in aufeinanderfolgenden Schichten angeordnet sind, die bei einer Eingangsschicht beginnen, die Eingangssignale (CLO-CL7) empfängt, die zwischen ihnen sukzessive verzögert werden, um eine einer gegebenen Frequenz entsprechende Periode (T) zu unterteilen, und bei einer Ausgangsschicht enden, die aus einem einzigen Gatter gebildet ist, das ein Ausgangssignal mit einer vielfachen Frequenz der gegebenen Frequenz liefert, wobei der Ausgang jedes Gatters mit Ausnahme des Ausgangsgatters mit einem Eingang eines Gatters der benachbarten folgenden Schicht verbunden ist, wobei jeder der beiden Eingänge jedes Gatters zwei komplementäre Signale (A, NA; B, NB) repräsentiert und jedes Gatter zwei Zellen (lla, llb) enthält, die als Antwort auf zwei jeweilige komplementäre Signale von einem der beiden Eingänge im wesentlichen gleichzeitig schalten und jeweilige Ausgangssignale liefern, die komplementäre Funktionen (XOR, NXOR) des Typs Exklusiv-ODER repräsentieren und den Ausgang des Gatters bilden, dadurch gekennzeichnet, daß, da jede Zelle in einer Technologie mit komplementären Feldeffekttransistoren mit isoliertem Gate (CMOS) hergestellt ist, jede Zelle ein erstes Paar komplementärer Transistoren (Na, Pa), die einen (A) der Eingänge empfangen, sowie ein zweites Paar komplementärer Transistoren (Na, Pa), die das komplementäre Signal (NA) des Eingangs empfangen, enthält, wobei die zwei Transistorpaare an einem gemeinsamen Punkt zwischen den Drains der komplementären Transistoren verbunden sind und wobei jeder der Transistoren dieser zwei Paare mit einem der zwei jeweiligen komplementären Transistoren (Nb, Pb), die die komplementären Signale des anderen Eingangs (B, NB) empfangen, in Serie geschaltet ist, wobei die beiden Paare und ihre komplementären Transistoren vier Zweige (14n, 14p, 14'n, 14'p) bilden, die im gemeinsamen Punkt vereinigt sind, der auch den Ausgang der Zelle bildet, wobei jeder (14p) der Zweige in zwei parallele Gabelzweige (14p, 114p) aufgespalten sind, in denen die Eingänge überkreuzt sind.

2. Frequenzmultiplizierer nach Anspruch 1, dadurch gekennzeichnet, daß die Anzahl der Schichten der Baumstruktur geradzahlig ist.

3. Frequenzmultiplizierer nach Anspruch 1 oder 2, dadurch gekennzeichnet, daß die Eingangssignale (CLO-CL7) der Baumstruktur in die entsprechenden Eingänge der Gatter der Eingangsschicht über Eingangszellen (15) eingegeben werden, die symmetrische komplementäre Signale jedes der Eingangssignale erzeugen.

4. Frequenzmultiplizierer nach Anspruch 3, dadurch gekennzeichnet, daß jede Eingangszelle einen Weg, der einen Inverter (16), sowie einen zweiten Weg umfaßt, der eine Anordnung (18) komplementärer Durchlaßtransistoren (Np, Pp) enthält, deren Drain-Source Pfade parallgeschaltet sind und deren Gates an zwei Versorgungspotentiale (Vdd, Vss) angeschlossen sind.

5. Integrierte Schaltung, dadurch gekennzeichnet, daß sie einen Frequenzmultiplizierer nach einem der Ansprüche 1 bis 4 enthält.

## Claims

1. Frequency multiplier comprising a tree (10) of Exclusive-OR type gates (11) with two inputs (A, B), the gates being arranged in successive layers starting from an input layer receiving input signals (CL0-CL7) delayed successively with respect to each other so as to share a period (T) corresponding to a given frequency, and ending at an output layer formed of a single gate supplying a multiple-frequency output signal of said given frequency, the output of each gate apart from the output gate being connected to an input of a gate of the next adjacent layer, each of the two inputs of each gate being representative of two complementary signals (A, NA; B, NB) and each gate comprising two cells (11a, 11b), which switch substantially simultaneously in response to the two respective complementary signals from one of the two inputs and which supply respective output signals representing the complementary functions (XOR, NXOR) of the Exclusive-OR type and constituting said output of the gate, characterised in that, each cell being made in a technology using complementary insulated-gate field-effect transistors (CMOS), each cell comprises a first pair of complementary transistors (Na, Pa) receiving one (A) of the inputs and a second pair of complementary transistors (Na, Pa) receiving the complementary signal (NA) from said input, the two pairs of transistors meeting at a common point between the drains of the complementary transistors and each of the transistors of these two pairs being mounted in series with one of two respective complementary transistors (Nb, Pb) receiving the complementary signals from the other input (N, NB), the two pairs and their complementary transistors forming four branches (14n, 14p, 14'n,m 14'p) meeting at the common point also constituting the output of the cell, each (14p) of the branches being split into two twin branches (14p, 114p) in parallel in which the inputs are crossed.

2. Frequency multiplier according to Claim 1, characterised in that the number of layers in the tree is even.

3. Frequency multiplier according to Claim 1 or 2, characterised in that the input signals (CL0-CL7) of the tree are applied to the respective inputs of the gates of the input layer via input cells (15) generating symmetrical signals complementary to each of the input signals.

4. Frequency multiplier according to Claim 3, characterised in that each input cell comprises a channel including an inverter (16) and a second channel including an assembly (18) of complementary passage transistors (Np, Pp) having their drain-source paths connected in parallel and their gates connected to two supply potentials (Vdd, Vss).

5. Integrated circuit, characterised in that it incorporates a frequency multiplier as defined by one of Claims 1 to 4.
